# EUROPEAN PATENT SPECIFICATION

(11) **EP 4 072 001 B1**
(45) Date of publication and mention of the grant of the patent: **20.11.2024**
(21) Application number: 21741781.5
(22) Date of filing: 14.01.2021
(51) Int. Cl.: H02N 11/00, H10N 10/17

(54) **THERMOELECTRIC POWER GENERATION DEVICE**
THERMOELEKTRISCHE ENERGIEERZEUGUNGSVORRICHTUNG
DISPOSITIF DE GÉNÉRATION D'ÉNERGIE THERMOÉLECTRIQUE

(30) Priority: 15.01.2020 JP 2020004708
(43) Date of publication of application: 12.10.2022
(73) Proprietor: KELK Ltd., Kanagawa 254-8543 (JP)
(72) Inventor: KISHIZAWA, Toshihiko, Hiratsuka-shi, Kanagawa 254-8543 (JP)
(74) Representative: Flügel Preissner Schober Seidel
(86) International application number: PCT/JP2021/000968
(87) International publication number: WO 2021/145359

(56) References cited:
- JP-A- 2013 045 929
- JP-A- 2013 045 929
- JP-A- 2015 171 308
- JP-A- 2015 171 308
- JP-A- 2016 012 957
- JP-A- 2016 012 957

## Description

### Field

The present disclosure relates to a thermoelectric power generator.

### Background

There is a known thermoelectric power generator including a thermoelectric power generation module that generates electric power using the Seebeck effect. The thermoelectric power generation module includes a heat receiver and a heat dissipater. The thermoelectric power generation module generates electric power by a temperature difference between the heat receiver and the heat dissipater. The larger the temperature difference between the heat receiver and the heat dissipater, the higher the power generation efficiency of the thermoelectric power generation module. Patent Literature 1 discloses a thermoelectric power generator including: a heat dissipating member joined to a low temperature portion-side of a thermoelectric conversion module; and a fan driven by the generated power of the thermoelectric conversion module and configured to cool the heat dissipating member. The heat dissipating member is cooled by the fan, thereby increasing the temperature difference between the high temperature portion (heat receiver) and the low temperature portion (heat dissipater).

### Citation List

### Patent Literature

Patent Literature 1: JP 2019-097335 A Furthermore document JP 2016 012957 A discloses a thermoelectric power generator comprising: a thermoelectric power generation module that includes a heat receiver and a heat dissipater and generates electric power by a temperature difference between the heat receiver and the heat dissipater; a cooling device that cools the heat dissipater; and a control device, wherein generated power of the thermoelectric power generation module is distributed to effective power used in an external load.

### Summary

### Technical Problem

When the generated power of the thermoelectric power generation module is distributed to the fan and an external load, an increase in the power distributed to the external load decreases the power distributed to the fan. The decrease in the power distributed to the fan deteriorates the cooling efficiency of the fan. When the cooling efficiency of the fan deteriorates, the temperature difference between the heat receiver and the heat dissipater does not increase, leading to the possibility of deterioration in power generation efficiency of the thermoelectric power generation module.

The present disclosure aims to suppress deterioration in the power generation efficiency of a thermoelectric power generation module.

### Solution to Problem

According to an aspect of the present invention, a thermoelectric power generator comprises: a thermoelectric power generation module that includes a heat receiver and a heat dissipater and generates electric power by a temperature difference between the heat receiver and the heat dissipater; a cooling device that cools the heat dissipater; and a control device, wherein generated power of the thermoelectric power generation module is distributed to consumption power used in the cooling device and effective power used in an external load, and the control device includes: a monitoring unit that monitors a state of the cooling device and outputs monitoring data; an adjustment unit capable of adjusting the effective power supplied to the external load; and a control command unit that outputs a control command that controls the adjustment unit based on the monitoring data.

### Advantageous Effects of Invention

According to the present disclosure, it is possible to suppress deterioration in power generation efficiency of the thermoelectric power generation module.

### Brief Description of Drawings

FIG. 1 is a view schematically illustrating a thermoelectric power generator according to a first embodiment.
FIG. 2 is a perspective view schematically illustrating the thermoelectric power generation module according to the first embodiment.
FIG. 3 is a view illustrating a use example of the thermoelectric power generator according to the first embodiment.
FIG. 4 is a block diagram illustrating the thermoelectric power generator according to the first embodiment.
FIG. 5 is a schematic diagram illustrating a relationship between a threshold and an effective power according to the first embodiment.
FIG. 6 is a flowchart illustrating an operation of the thermoelectric power generator according to the first embodiment.
FIG. 7 is a diagram illustrating an experimental result on an effect of the thermoelectric power generator according to the first embodiment.
FIG. 8 is a block diagram illustrating a thermoelectric power generator according to a second embodiment.
FIG. 9 is a block diagram illustrating a thermoelectric power generator according to a third embodiment.
FIG. 10 is a view schematically illustrating a thermoelectric power generator according to a fourth embodiment.
FIG. 11 is a view schematically illustrating a thermoelectric power generator according to a fifth embodiment.
FIG. 12 is a view schematically illustrating a thermoelectric power generator according to a sixth embodiment.

### Description of Embodiments

Hereinafter, embodiments according to the present disclosure will be described with reference to the drawings, but the present disclosure is not limited to the embodiments. The constituents described in the embodiments below can be appropriately combined with each other. In some cases, a portion of the constituents is not utilized.

### [First embodiment]

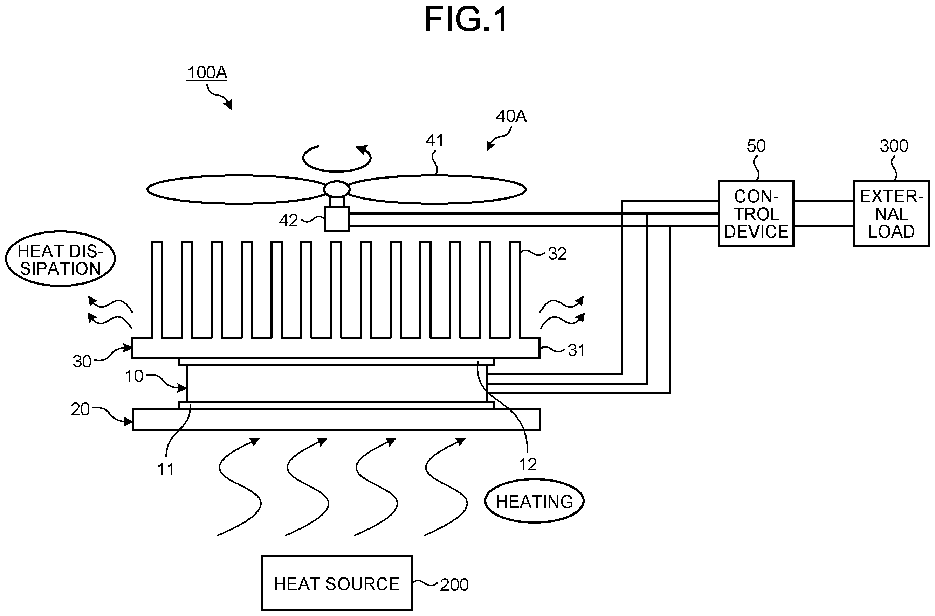

FIG. 1 is a view schematically illustrating a thermoelectric power generator 100A according to the present embodiment. As illustrated in FIG. 1, the thermoelectric power generator 100A includes a thermoelectric power generation module 10 having a heat receiver 11 and a heat dissipater 12, a heat receiving member 20 connected to the heat receiver 11 of the thermoelectric power generation module 10, a heat dissipating member 30 connected to the heat dissipater 12 of the thermoelectric power generation module 10, a cooling device 40A that cools the heat dissipater 12 via the heat dissipating member 30, and a control device 50.

The thermoelectric power generation module 10 generates electric power using the Seebeck effect. The heat receiver 11 of the thermoelectric power generation module 10 is heated by a heat source 200 via the heat receiving member 20. The heat dissipater 12 of the thermoelectric power generation module 10 is cooled by the cooling device 40A via the heat dissipating member 30. In the state where the heat receiver 11 is heated and the heat dissipater 12 is cooled, a temperature difference occurs between the heat receiver 11 and the heat dissipater 12. The thermoelectric power generation module 10 generates electric power by the temperature difference between the heat receiver 11 and the heat dissipater 12.

The heat receiving member 20 is connected to the heat receiver 11 of the thermoelectric power generation module 10. The heat receiving member 20 has a plate shape. The heat receiving member 20 is formed of a metal material such as aluminum or copper. The heat receiving member 20 is heated by the heat source 200, whereby the heat receiver 11 is heated.

The heat dissipating member 30 is connected to the heat dissipater 12 of the thermoelectric power generation module 10. The heat dissipating member 30 includes: a plate portion 31 connected to the heat dissipater 12; and a fin portion 32 connected to the plate portion 31. The fin portion 32 is a pin fin or a plate fin. The heat dissipating member 30 is formed of a metal material such as aluminum or copper. The heat dissipating member 30 is a heat sink that removes heat from the heat dissipater 12. The heat dissipating member 30 is cooled by the cooling device 40A, whereby the heat dissipater 12 is cooled.

The cooling device 40A cools the heat dissipater 12 via the heat dissipating member 30. In the present embodiment, the cooling device 40A includes a fan 41 and a motor 42 that rotates the fan 41. The fan 41 is disposed so as to face the heat dissipating member 30. The fan 41 is rotated by the driving of the motor 42. When the fan 41 rotates, an airflow is generated in at least a part of the surroundings of the heat dissipating member 30. The generation of the airflow in at least a part of the surroundings of the heat dissipating member 30 cools the heat dissipating member 30.

Generated power Pg of the thermoelectric power generation module 10 is distributed to consumption power Pc used in the cooling device 40A and effective power Pe used in an external load 300. The generated power Pg refers to power generated by the thermoelectric power generation module 10. The consumption power Pc refers to power supplied from the thermoelectric power generation module 10 to the cooling device 40A and consumed by the cooling device 40A. The effective power Pe refers to power supplied from the thermoelectric power generation module 10 to the external load 300 and consumed by the external load 300. The generated power Pg, the consumption power Pc, and the effective power Pe have a relationship expressed by the following Formula (1).

[Effective power Pe] = [generated power Pg] - [consumption power Pc]

The generated power Pg is proportional to the square of a temperature difference between a heat receiver-side end and a heat dissipater-side end of a thermoelectric semiconductor element 13. Accordingly, by cooling the heat dissipater 12 by the cooling device 40A so as to increase the temperature difference between the heat receiver 11 and the heat dissipater 12, power generation efficiency of the thermoelectric power generation module 10 improves. That is, when the heat dissipater 12 is cooled by the cooling device 40A, the thermoelectric power generation module 10 can output a large generated power Pg.

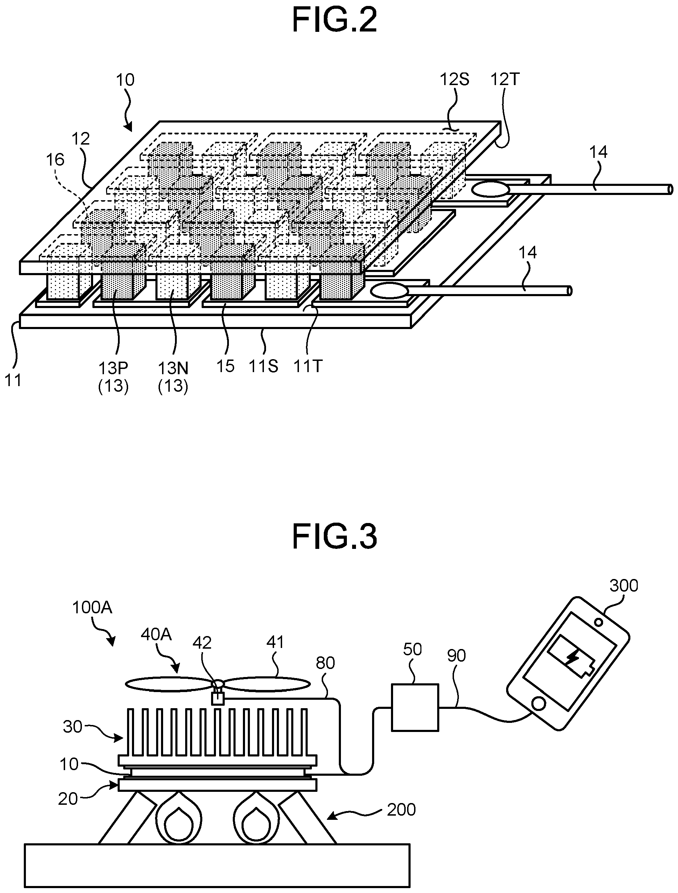

FIG. 2 is a perspective view schematically illustrating the thermoelectric power generation module 10 according to the present embodiment. The thermoelectric power generation module 10 includes the heat receiver 11, the heat dissipater 12, a plurality of the thermoelectric semiconductor elements 13 disposed between the heat receiver 11 and the heat dissipater 12, a first electrode 15, and a second electrode 16.

The heat receiver 11 has a plate shape. The heat receiver 11 is formed of an electrically insulating material such as ceramics or polyimide. The heat receiver 11 has an outer surface 11S connected to the heat receiving member 20 and an inner surface 11T facing a direction opposite to the outer surface 11S. The outer surface 11S and the inner surface 11T are parallel to each other. The first electrode 15 is disposed on the inner surface 11T. In the example illustrated in FIG. 2, the outer surface 11S faces downward, and the inner surface 11T faces upward.

The heat dissipater 12 has a plate shape. The heat dissipater 12 is formed of an electrically insulating material such as ceramics or polyimide. The heat dissipater 12 has an outer surface 12S connected to the heat dissipating member 30 and an inner surface 12T facing an opposite direction of the outer surface 12S. The outer surface 12S and the inner surface 12T are parallel to each other. The second electrode 16 is disposed on the inner surface 12T. In the example illustrated in FIG. 2, the outer surface 12S faces upward, and the inner surface 12T faces downward.

The heat receiver 11 and the heat dissipater 12 are disposed such that the inner surface 11T and the inner surface 12T face each other. The inner surface 11T and the inner surface 12T are parallel to each other.

The thermoelectric semiconductor element 13 is disposed between the heat receiver 11 and the heat dissipater 12. The thermoelectric semiconductor element 13 includes a BiTe thermoelectric material, for example. The thermoelectric semiconductor element 13 includes a p-type thermoelectric semiconductor element 13P and an n-type thermoelectric semiconductor element 13N. In a plane parallel to each of the inner surface 11T and the inner surface 12T, the p-type thermoelectric semiconductor elements 13P and the n-type thermoelectric semiconductor elements 13N are alternately arranged.

A plurality of first electrodes 15 is disposed on the inner surface 11T of the heat receiver 11. The plurality of first electrodes 15 is arranged on the inner surface 11T at intervals. The first electrode 15 is connected to each of the p-type thermoelectric semiconductor element 13P and the n-type thermoelectric semiconductor element 13N. One end of the p-type thermoelectric semiconductor element 13P and one end of the n-type thermoelectric semiconductor element 13N are connected to the first electrode 15.

A plurality of second electrodes 16 is disposed on the inner surface 12T of the heat dissipater 12. The plurality of second electrodes 16 is arranged on the inner surface 12T at intervals. The second electrode 16 is connected to each of the p-type thermoelectric semiconductor element 13P and the n-type thermoelectric semiconductor element 13N. The other end of the p-type thermoelectric semiconductor element 13P and the other end of the n-type thermoelectric semiconductor element 13N are connected to the second electrode 16.

When the heat receiver 11 is heated and the heat dissipater 12 is cooled, a temperature difference occurs between one end and the other end on each of the p-type thermoelectric semiconductor element 13P and the n-type thermoelectric semiconductor element 13N. When a temperature difference occurs between one end and the other end of the p-type thermoelectric semiconductor element 13P, holes move in the p-type thermoelectric semiconductor element 13P. When a temperature difference occurs between one end and the other end of the n-type thermoelectric semiconductor element 13N, electrons move in the n-type thermoelectric semiconductor element 13N. The p-type thermoelectric semiconductor element 13P and the n-type thermoelectric semiconductor element 13N are connected to each other via the first electrode 15 and the second electrode 16. The holes and electrons lead to a potential difference occurring between the first electrode 15 and the second electrode 16. The occurrence of the potential difference between first electrode 15 and second electrode 16 causes the thermoelectric power generation module 10 to generate electric power.

The first electrode 15 is connected to a lead wire 14. The generated power Pg of the thermoelectric power generation module 10 is output through the lead wire 14.

FIG. 3 is a view illustrating a use example of the thermoelectric power generator 100A according to the present embodiment. The thermoelectric power generator 100A is installed onto the heat source 200. In the example illustrated in FIG. 3, the heat source 200 is a portable stove. The heat source 200 is not limited to the portable stove. Examples of the heat source 200 include exhaust heat from a fireplace heater, a bonfire, a charcoal fire, and industrial equipment. With the heat receiving member 20 heated by the heat source 200, and with the heat dissipating member 30 cooled by the cooling device 40A, the thermoelectric power generator 100A generates electric power.

The thermoelectric power generator 100A includes: a first power line 80 connecting the thermoelectric power generation module 10 and the motor 42 of the cooling device 40A to each other; and a second power line 90 connecting the thermoelectric power generation module 10 and the external load 300 to each other. Each of the first power line 80 and the second power line 90 includes the above-described lead wire 14. Each of the first power line 80 and the second power line 90 includes an electric cable different from the lead wire 14. At least one of the first power line 80 or the second power line 90 may be a universal serial bus (USB) cable, for example.

Of the generated power Pg of the thermoelectric power generation module 10, the consumption power Pc used in the motor 42 of the cooling device 40A is supplied from the thermoelectric power generation module 10 to the motor 42 via the first power line 80. Of the generated power Pg of the thermoelectric power generation module 10, the effective power Pe used in the external load 300 is supplied from the thermoelectric power generation module 10 to the external load 300 via the second power line 90.

The external load 300 is an electric device or an electronic device that is driven by the effective power Pe. Examples of the external load 300 include a smartphone and a tablet personal computer. When the external load 300 has a rechargeable battery, the rechargeable battery of the external load 300 is charged by the effective power Pe supplied from the thermoelectric power generation module 10 to the external load 300. The thermoelectric power generator 100A can function as a charger of the external load 300. For example, during an emergency or outdoor activity, the thermoelectric power generator 100A can charge a rechargeable battery of the external load 300.

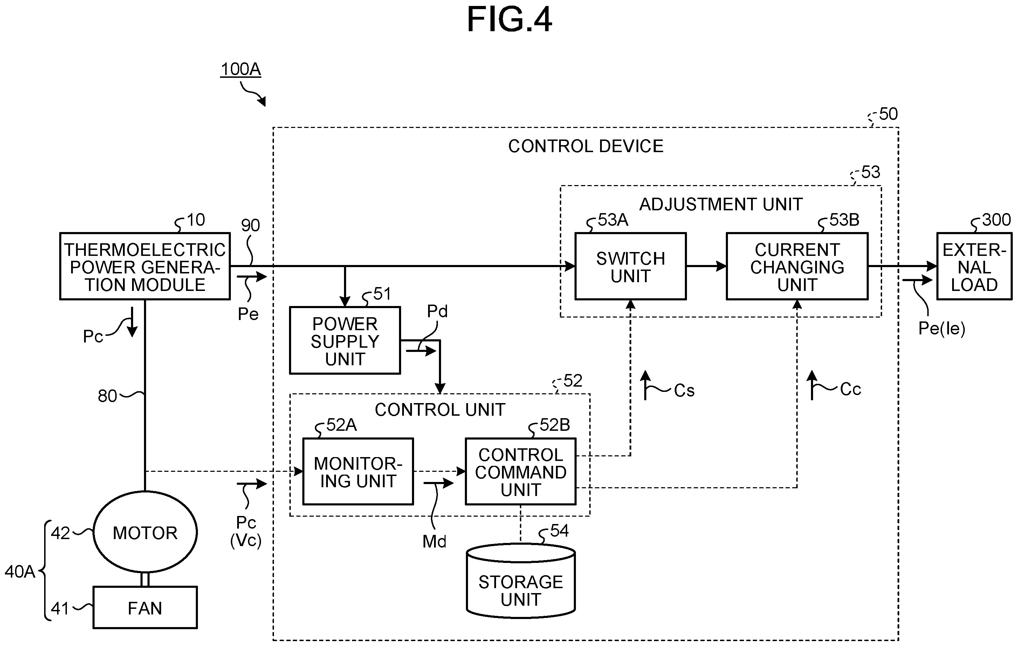

FIG. 4 is a block diagram illustrating the thermoelectric power generator 100A according to the present embodiment. As illustrated in FIG. 4, the thermoelectric power generator 100A includes: the thermoelectric power generation module 10: the cooling device 40A including the motor 42; the control device 50; the first power line 80 connecting the thermoelectric power generation module 10 and the cooling device 40A to each other; and the second power line 90 connecting the thermoelectric power generation module 10 and the external load 300 to each other. At least a part of the control device 50 is disposed in the second power line 90.

The generated power Pg of the thermoelectric power generation module 10 is distributed to the consumption power Pc used in the motor 42 of the cooling device 40A and the effective power Pe used in the external load 300. The consumption power Pc is supplied from the thermoelectric power generation module 10 to the motor 42 via the first power line 80. The effective power Pe is supplied from the thermoelectric power generation module 10 to the external load 300 via the second power line 90.

The control device 50 monitors the state of the cooling device 40A. The control device 50 adjusts the effective power Pe supplied from the thermoelectric power generation module 10 to the external load 300 based on monitoring data Md indicating a monitoring result of the state of the cooling device 40A.

In the present embodiment, the control device 50 monitors the consumption power Pc of the cooling device 40A. The consumption power Pc of the cooling device 40A includes the consumption power Pc of the motor 42.

An increase in the effective power Pe distributed to the external load 300 causes a voltage drop, leading to a decrease in the consumption power Pc distributed to the motor 42. The decrease in the consumption power Pc distributed to the motor 42 lowers the rotational speed of the fan 41, leading to the deterioration in the cooling efficiency of the fan 41. When the cooling efficiency of the fan 41 deteriorates, a temperature difference between the heat receiver 11 and the heat dissipater 12 of the thermoelectric power generation module 10 does not increase, leading to the possibility of deterioration in the power generation efficiency of the thermoelectric power generation module 10.

In addition, the increase in the effective power Pe distributed to the external load 300 can cause shortage of the consumption power Pc distributed to the motor 42, leading to a possibility of stop of the driving of the motor 42. The stop of the driving of the motor 42 and the stop of the rotation of the fan 41 during heating of the thermoelectric power generation module 10 by the heat source 200 would lead to excessive heating of the thermoelectric power generation module 10. The excessive heating of the thermoelectric power generation module 10 leads to the possibility of deterioration and failure in the thermoelectric power generator 100A.

In the present embodiment, the control device 50 monitors the consumption power Pc distributed from the thermoelectric power generation module 10 to the motor 42. An increase in the effective power Pe distributed from the thermoelectric power generation module 10 to the external load 300 will decrease the consumption power Pc distributed to the motor 42. When the consumption power Pc distributed from the thermoelectric power generation module 10 to the motor 42 decreases, the control device 50 decreases the effective power Pe distributed from the thermoelectric power generation module 10 to the external load 300. The decrease in the effective power Pe distributed to the external load 300 will increase the consumption power Pc distributed to the motor 42. With the increase in the consumption power Pc distributed to the motor 42, it is possible to suppress the decrease in the rotational speed of the fan 41 and the stop of the rotation of the fan 41. This makes it possible to sufficiently cool the heat dissipater 12 by the fan 41. This can achieve a large temperature difference between the heat receiver 11 and the heat dissipater 12, leading to the suppression of the decrease in power generation efficiency of the thermoelectric power generation module 10.

As illustrated in FIG. 4, the control device 50 includes a power supply unit 51, a control unit 52, an adjustment unit 53, and a storage unit 54. The control unit 52 includes a monitoring unit 52A and a control command unit 52B. The adjustment unit 53 the adjustment unit 53 includes a switch unit 53A and a current changing unit 53B.

In the present embodiment, the control device 50 includes hardware such as a control circuit. The power supply unit 51 includes a DC power supply device. The control unit 52 includes an integrated circuit (IC). The switch unit 53A includes a field effect transistor (FET). The current changing unit 53B includes a DC/DC converter. The storage unit 54 includes a nonvolatile memory such as a read only memory (ROM) or flash memory.

The power supply unit 51 functions as a power supply of the control unit 52. The thermoelectric power generation module 10 can supply a part of the effective power Pe to the power supply unit 51 via the second power line 90. The power supply unit 51 outputs drive power Pd for driving the control unit 52 based on the effective power Pe supplied from the thermoelectric power generation module 10.

The monitoring unit 52A monitors the state of the cooling device 40A and outputs the monitoring data Md indicating the monitoring result of the state of the cooling device 40A to the control command unit 52B. In the present embodiment, the monitoring unit 52A monitors the consumption power Pc of the cooling device 40A. The consumption power Pc of the cooling device 40A includes the consumption power Pc of the motor 42. The monitoring data Md output from the monitoring unit 52A to the control command unit 52B indicates the consumption power Pc of the motor 42.

In the present embodiment, the consumption power Pc of the cooling device 40A includes a voltage Vc applied to the cooling device 40A. The voltage Vc applied to the cooling device 40A includes the voltage Vc applied to the motor 42. In the present embodiment, the monitoring unit 52A monitors the voltage Vc applied to the motor 42. The monitoring data Md output from the monitoring unit 52A to the control command unit 52B indicates the voltage Vc applied to the motor 42.

The consumption power Pc supplied from the thermoelectric power generation module 10 to the motor 42 corresponds to the voltage Vc applied to the motor 42 on a one-to-one basis. The greater the consumption power Pc, the higher the voltage Vc applied to the motor 42; the smaller the consumption power Pc, the lower the voltage Vc applied to the motor 42. By monitoring the voltage Vc applied to the motor 42, the monitoring unit 52A can monitor the consumption power Pc of the motor 42.

The adjustment unit 53 can adjust the effective power Pe supplied to the external load 300. The adjustment unit 53 is disposed in the second power line 90 between the thermoelectric power generation module 10 and the external load 300.

In the present embodiment, the effective power Pe of the external load 300 includes a current Ie supplied to the external load 300. In the present embodiment, the adjustment unit 53 adjusts the current Ie supplied to the external load 300.

The effective power Pe supplied from the thermoelectric power generation module 10 to the external load 300 and the current Ie supplied to the external load 300 correspond to each other on a one-to-one basis. The greater the effective power Pe, the greater the current Ie supplied to the external load 300; the smaller the effective power Pe, the smaller the current Ie supplied to the external load 300. By adjusting the current Ie supplied to the external load 300, the adjustment unit 53 can adjust the effective power Pe supplied to the external load 300.

The switch unit 53A switches between supply and stop of supply of the current Ie to the external load 300. The current changing unit 53B adjusts the value of the current Ie to be supplied to the external load 300. The switch unit 53A and the current changing unit 53B are arranged in series.

The control command unit 52B outputs a control command that controls the adjustment unit 53 based on the monitoring data Md output from the monitoring unit 52A. The control command output from the control command unit 52B includes a switching command Cs output to the switch unit 53A and a change command Cc output to the current changing unit 53B. The switch unit 53A switches between supply and stop of supply of the current Ie to the external load 300 based on the switching command Cs. The current changing unit 53B adjusts the value of the current Ie to be supplied to the external load 300 based on the change command Cc.

When having determined that the consumption power Pc of the cooling device 40A has decreased based on the monitoring data Md output from the monitoring unit 52A, the control command unit 52B outputs a control command to decrease the effective power Pe of the external load 300. When having determined that the consumption power Pc of the cooling device 40A has increased based on the monitoring data Md output from the monitoring unit 52A, the control command unit 52B outputs a control command to increase the effective power Pe of the external load 300.

The storage unit 54 stores a threshold Sh related to the monitoring data Md. In the present embodiment, the storage unit 54 stores the threshold Sh related to the consumption power Pc of the cooling device 40A. The threshold Sh is a predetermined value.

The control command unit 52B outputs a control command based on a result of comparison between the monitoring data Md indicating the consumption power Pc of the cooling device 40A output from the monitoring unit 52A and the threshold Sh stored in the storage unit 54. The threshold Sh includes: a change threshold Shv related to the change of the value of the effective power Pe; and a stop threshold Shp related to the stop of supply of the effective power Pe. The stop threshold Shp is a value lower than the change threshold Shv.

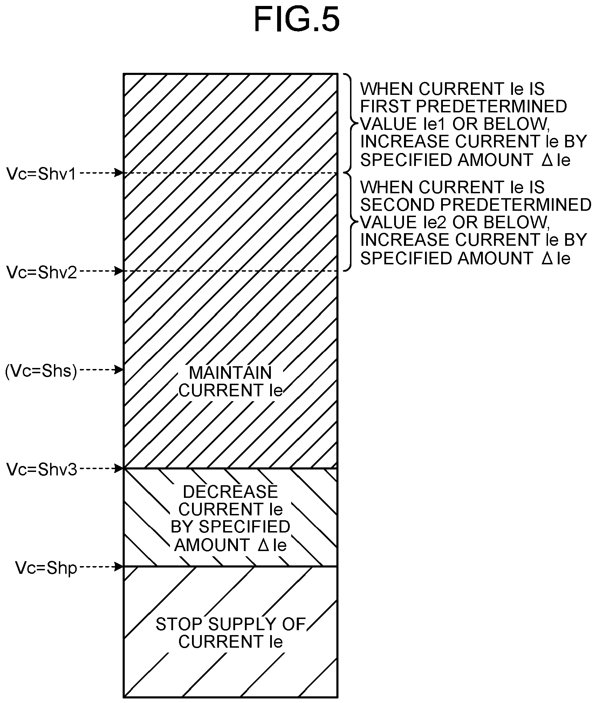

FIG. 5 is a schematic diagram illustrating a relationship between the threshold Sh and the effective power Pe according to the present embodiment. The threshold Sh is a threshold related to the voltage Vc applied to the motor 42. The change threshold Shv is a threshold related to the change of the value of the current Ie supplied to the external load 300. The stop threshold Shp is a threshold related to the stop of supply of the current Ie to the external load 300.

As illustrated in FIG. 5, the change threshold Shv includes a first change threshold Shv1, a second change threshold Shv2 lower than the first change threshold Shv1, and a third change threshold Shv3 lower than the second change threshold Shv2. The stop threshold Shp is lower than the change threshold Shv. The first change threshold Shv1 is 7.0 [V], for example. The second change threshold Shv2 is 6.5 [V], for example. The third change threshold Shv3 is 5.5 [V], for example. The stop threshold Shp is 5.0 [V], for example.

When the voltage Vc monitored by the monitoring unit 52A exceeds the third change threshold Shv3, the control command unit 52B outputs a control command so as to enable the current Ie supplied to the external load 300 to maintain a present value. For example, when the value of the current Ie currently supplied to the external load 300 is 600 [mA] and the voltage Vc monitored by the monitoring unit 52A exceeds the third change threshold Shv3, the current Ie supplied to the external load 300 is maintained at 600 [mA].

When the voltage Vc monitored by the monitoring unit 52A decreases to the third change threshold Shv3 or below, the control command unit 52B outputs a control command so as to decrease the current Ie supplied to the external load 300 by a specified amount ΔIe. The specified amount ΔIe is 50 [mA], for example. For example, when the value of the current Ie currently supplied to the external load 300 is 600 [mA] and the voltage Vc monitored by the monitoring unit 52A decreases to the third change threshold Shv3 or below, the current Ie supplied to the external load 300 is decreased to 550 [mA].

When the voltage Vc monitored by the monitoring unit 52A decreases to the stop threshold Shp or below, the control command unit 52B outputs a control command to stop the supply of the current Ie to the external load 300.

When the voltage Vc monitored by the monitoring unit 52A exceeds the first change threshold Shv1 and the value of the current Ie currently supplied to the external load 300 is a first predetermined value Ie1 or below, the control command unit 52B outputs a control command to increase the current Ie supplied to the external load 300 by a specified amount ΔIe. The first predetermined value Ie1 is 750 [mA], for example. The specified amount ΔIe is 50 [mA], for example. For example, when the voltage Vc monitored by the monitoring unit 52A exceeds the first change threshold Shv1 and the value of the current Ie currently supplied to the external load 300 is equal to or below 700 [mA] being the first predetermined value Ie1, the current Ie supplied to the external load 300 is to be increased to 750 [mA].

When the voltage Vc monitored by the monitoring unit 52A is between the first change threshold Shv1 and the second change threshold Shv2, and the value of the current Ie currently supplied to the external load 300 is a second predetermined value Ie2 or below, the control command unit 52B outputs a control command to increase the current Ie supplied to the external load 300 by the specified amount ΔIe. The second predetermined value Ie2 is a value lower than the first predetermined value Ie1. The second predetermined value Ie2 is 650 [mA], for example. The specified amount ΔIe is 50 [mA], for example. For example, when the voltage Vc monitored by the monitoring unit 52A is between the first change threshold Shv1 and the second change threshold Shv2, and the value of the current Ie currently supplied to the external load 300 is 600 [mA] lower than the second predetermined value Ie2, the current Ie supplied to the external load 300 is increased to 650 [mA] .

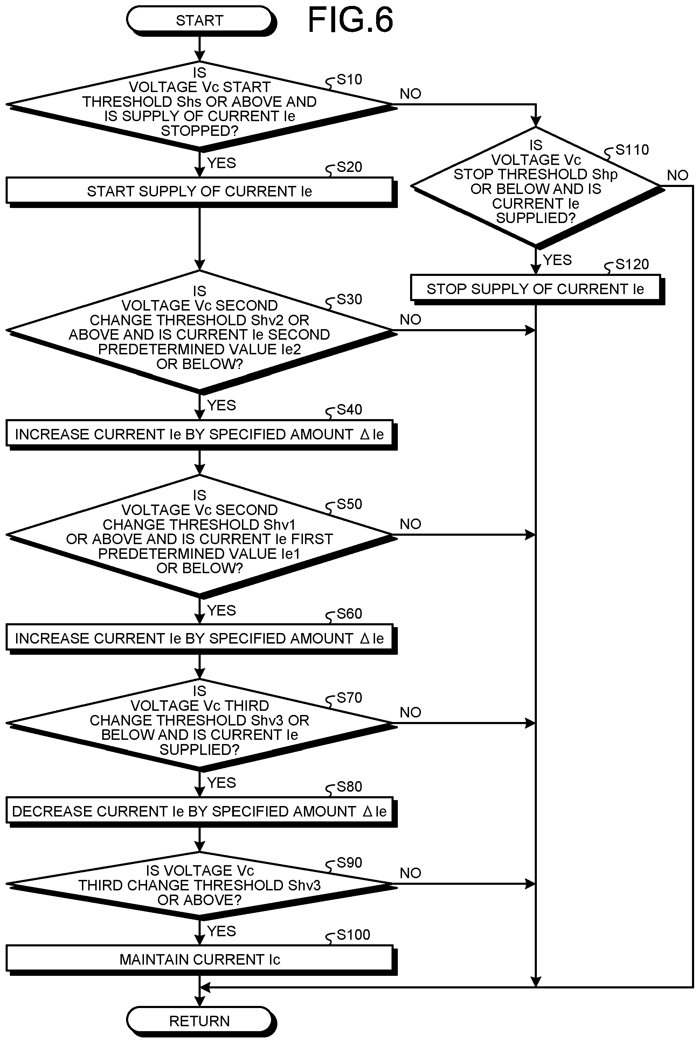

FIG. 6 is a flowchart illustrating an operation of the thermoelectric power generator according to the present embodiment. After installation of the thermoelectric power generator 100A onto the heat source 200, the thermoelectric power generation module 10 starts power generation. When the thermoelectric power generation module 10 starts power generation, the voltage Vc is applied to the motor 42. The monitoring unit 52A monitors the voltage Vc applied to the motor 42.

The control command unit 52B determines whether the voltage Vc monitored by the monitoring unit 52A is a start threshold Shs or above and the switch unit 53A has stopped the supply of the current Ie (step S10).

The start threshold Shs is a threshold Sh related to the voltage Vc. As illustrated in FIG. 5, the start threshold Shs is a value lower than the second change threshold Shv2 and higher than the third change threshold Shv3. The start threshold Shs is 6.0 [V], for example.

When having determined in step S10 that the voltage Vc is the start threshold Shs or above and the switch unit 53A has stopped the supply of the current Ie (step S10: Yes), the control command unit 52B outputs the switching command Cs to the switch unit 53A to start the supply of the current Ie to the external load 300 (step S20) .

In step S20, the current Ie supplied to the external load 300 is 150 [mA], for example. That is, the initial value of the current Ie immediately after the start of the supply of the current Ie is 150 [mA] lower than the stop threshold Shp.

The control command unit 52B determines whether the voltage Vc monitored by the monitoring unit 52A is the second change threshold Shv2 or above and the current Ie supplied to the external load 300 is the second predetermined value Ie2 or below (step S30).

When having determined in step S30 that the voltage Vc is the second change threshold Shv2 or above and the current Ie supplied to the external load 300 is the second predetermined value Ie2 or below (step S30: Yes), the control command unit 52B outputs the change command Cc to the current changing unit 53B to increase the current Ie supplied to the external load 300 by the specified amount ΔIe (step S40) .

The control command unit 52B determines whether the voltage Vc monitored by the monitoring unit 52A is the first change threshold Shv1 or above and the current Ie supplied to the external load 300 is the first predetermined value Ie1 or below (step S50).

When having determined in step S50 that the voltage Vc is the first change threshold Shv1 or above and the current Ie supplied to the external load 300 is the first predetermined value Ie1 or below (step S50: Yes), the control command unit 52B outputs the change command Cc to the current changing unit 53B to increase the current Ie supplied to the external load 300 by the specified amount ΔIe (step S60) .

The control command unit 52B determines whether the voltage Vc monitored by the monitoring unit 52A is the third change threshold Shv3 or below and the current Ie is supplied to the external load 300 (step S70).

When having determined in step S70 that the voltage Vc is the third change threshold Shv3 or below and the current Ie is supplied to the external load 300 (step S70: Yes), the control command unit 52B outputs the change command Cc to the current changing unit 53B so as to decrease the current Ie supplied to the external load 300 by the specified amount ΔIe (step S80).

The control command unit 52B determines whether the voltage Vc monitored by the monitoring unit 52A is the third change threshold Shv3 or above (step S90).

When having determined in step S90 that the voltage Vc is the third change threshold Shv3 or above (step S90: Yes), the control command unit 52B maintains the value of the current Ie supplied to the external load 300 (step S100).

When having determined in step S10 that the voltage Vc is not the start threshold Shs or above, or the current Ie is supplied to the external load 300 (step S10: No), the control command unit 52B determines whether the voltage Vc monitored by the monitoring unit 52A is the stop threshold Shp or below and the current Ie is supplied to the external load 300 (step S110).

When having determined in step S110 that the voltage Vc monitored by the monitoring unit 52A is the stop threshold Shp or below and the current Ie is supplied to the external load 300 (step S110: Yes), the control command unit 52B outputs the switching command Cs to the switch unit 53A so as to stop the supply of the current Ie to the external load 300 (step S120).

When having determined in step S30 that the voltage Vc is not the second change threshold Shv2 or above, or the current Ie supplied to the external load 300 is not the second predetermined value Ie2 or below (step S30: No), the control command unit 52B returns to the processing of step S10.

When having determined in step S50 that the voltage Vc is not the first change threshold Shv1 or above, or the current Ie supplied to the external load 300 is not the first predetermined value Ie1 or below (step S50: No), the control command unit 52B returns to the processing of step S10.

When having determined in step S70 that the voltage Vc is not the third change threshold Shv3 or below, or the current Ie is not supplied to the external load 300 (step S70: No), the control command unit 52B returns to the processing of step S10.

When having determined in step S90 that the voltage Vc is not the third change threshold Shv3 or above (step S90: No), the control command unit 52B returns to the processing of step S10.

When having determined in step S110 that the voltage Vc monitored by the monitoring unit 52A is not the stop threshold Shp or below, or the current Ie is not supplied to the external load 300 (step S110: No), the control command unit 52B returns to the processing of step S10.

### [Effects]

As described above, according to the present embodiment, when the generated power Pg of the thermoelectric power generation module 10 is distributed to the consumption power Pc used in the cooling device 40A and the effective power Pe used in the external load 300, the effective power Pe supplied to the external load 300 is adjusted based on the monitoring data Md indicating the state of the cooling device 40A. A change in the effective power Pe changes the state of the cooling device 40A. Therefore, by monitoring the state of the cooling device 40A and adjusting the effective power Pe based on the monitoring data Md indicating the state of the cooling device 40A, the control device 50 can suppress the deterioration of the cooling efficiency of the cooling device 40A. The suppression of the deterioration in the cooling efficiency of the cooling device 40A makes it possible to sufficiently cool the heat dissipater 12. This increases the temperature difference between the heat receiver 11 and the heat dissipater 12. The increased temperature difference between the heat receiver 11 and the heat dissipater 12 makes it possible to suppress the deterioration in power generation efficiency of the thermoelectric power generation module 10.

In the present embodiment, the monitoring data Md is the consumption power Pc of the motor 42 of the cooling device 40A. The monitoring unit 52A monitors the consumption power Pc distributed from the thermoelectric power generation module 10 to the motor 42 of the cooling device 40A. An increase in the effective power Pe distributed from the thermoelectric power generation module 10 to the external load 300 will decrease the consumption power Pc distributed to the motor 42. When having determined the decrease in the consumption power Pc distributed from the thermoelectric power generation module 10 to the motor 42 based on monitoring data Md acquired by the monitoring unit 52A, the control command unit 52B decreases the effective power Pe to be distributed from the thermoelectric power generation module 10 to the external load 300. The decrease in the effective power Pe distributed to the external load 300 will increase the consumption power Pc distributed to the motor 42. The increase in the consumption power Pc and the increase in the voltage Vc applied to the motor 42 will suppress a decrease in the rotational speed of the fan 41 and stop of the rotation of the fan 41. Therefore, due to sufficient cooling by the fan 41, excessive heating of the thermoelectric power generation module 10 is suppressed. In addition, the heat dissipater 12 is sufficiently cooled by the fan 41, increasing the temperature difference between the heat receiver 11 and the heat dissipater 12. This makes it possible to suppress the deterioration in power generation efficiency of the thermoelectric power generation module 10.

When having determined the increase in the consumption power Pc distributed from the thermoelectric power generation module 10 to the motor 42 based on the monitoring data Md acquired by the monitoring unit 52A, the control command unit 52B decreases the effective power Pe to be distributed from the thermoelectric power generation module 10 to the external load 300. When the temperature difference between the heat receiver 11 and the heat dissipater 12 is sufficient and the generated power Pg is sufficient, the control command unit 52B can increase both the consumption power Pc and the effective power Pe.

In the present embodiment, when the consumption power Pc distributed from the thermoelectric power generation module 10 to the motor 42 decreases to the predetermined third change threshold Shv3 or below, the control command unit 52B outputs the change command Cc to the current changing unit 53B to decrease the effective power Pe supplied from the thermoelectric power generation module 10 to the external load 300. A decrease in the effective power Pe supplied to the external load 300 will increase the consumption power Pc supplied to the motor 42. The increase in the consumption power Pc and the increase in the voltage Vc applied to the motor 42 will suppress a decrease in the rotational speed of the fan 41 and stop of the rotation of the fan 41. Therefore, due to sufficient cooling by the fan 41, excessive heating of the thermoelectric power generation module 10 is suppressed. In addition, the heat dissipater 12 is sufficiently cooled by the fan 41, increasing the temperature difference between the heat receiver 11 and the heat dissipater 12. This makes it possible to suppress the deterioration in power generation efficiency of the thermoelectric power generation module 10.

In the present embodiment, when the consumption power Pc distributed from the thermoelectric power generation module 10 to the motor 42 decreases to the predetermined stop threshold Shp or below, the control command unit 52B outputs the switching command Cs to the switch unit 53A to stop supply of the effective power Pe from the thermoelectric power generation module 10 to the external load 300. The stop of supply of the effective power Pe to the external load 300 will increase the consumption power Pc supplied to the motor 42. The increase in the consumption power Pc and the increase in the voltage Vc applied to the motor 42 will suppress a decrease in the rotational speed of the fan 41 and stop of the rotation of the fan 41. Therefore, due to sufficient cooling by the fan 41, excessive heating of the thermoelectric power generation module 10 is suppressed. In addition, the heat dissipater 12 is sufficiently cooled by the fan 41, increasing the temperature difference between the heat receiver 11 and the heat dissipater 12. This makes it possible to suppress the deterioration in power generation efficiency of the thermoelectric power generation module 10.

In the present embodiment, when the consumption power Pc distributed from the thermoelectric power generation module 10 to the motor 42 increases to the predetermined second change threshold Shv2 or above, the control command unit 52B outputs the change command Cc to the current changing unit 53B to increase the effective power Pe supplied from the thermoelectric power generation module 10 to the external load 300. Furthermore, when the consumption power Pc increases to the first change threshold Shv1 or above, the control command unit 52B further increases the effective power Pe supplied from the thermoelectric power generation module 10 to the external load 300. This makes it possible supply the appropriate effective power Pe to the external load 300 while suppressing deterioration in the cooling efficiency of the cooling device 40A.

In the present embodiment, the consumption power Pc of the cooling device 40A includes the voltage Vc applied to the motor 42, and the effective power Pe of the external load 300 includes the current Ie supplied to the external load 300. The monitoring unit 52A monitors the voltage Vc, and the control command unit 52B outputs a control command for adjusting the current Ie to the adjustment unit 53 based on the monitoring data Md indicating the voltage Vc. An increase in the current Ie supplied from the thermoelectric power generation module 10 to the external load 300 decreases the voltage Vc applied to the motor 42. When having determined the decrease in the voltage Vc applied to the motor 42 based on the monitoring data Md acquired by the monitoring unit 52A, the control command unit 52B decreases the current Ie supplied from the thermoelectric power generation module 10 to the external load 300. The decrease in the current Ie supplied to the external load 300 increases the voltage Vc applied to the motor 42. The increase in the voltage Vc applied to the motor 42 suppresses a decrease in the rotational speed of the fan 41 and the stop of the rotation of the fan 41. Therefore, due to sufficient cooling by the fan 41, excessive heating of the thermoelectric power generation module 10 is suppressed. In addition, the heat dissipater 12 is sufficiently cooled by the fan 41, increasing the temperature difference between the heat receiver 11 and the heat dissipater 12. This makes it possible to suppress the deterioration in power generation efficiency of the thermoelectric power generation module 10.

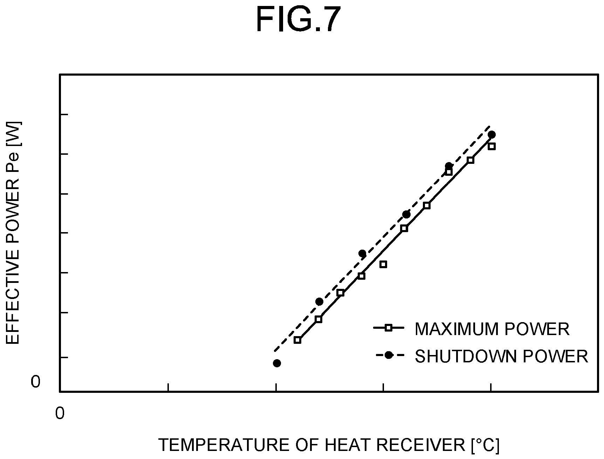

FIG. 7 is a diagram illustrating an experimental result on the effect of the thermoelectric power generator 100A according to the present embodiment. In the graph illustrated in FIG. 7, the horizontal axis represents the temperature of the heat receiver 11, and the vertical axis represents the effective power Pe used in the external load 300. In FIG. 7, the maximum power refers to a maximum value of the effective power Pe that can be supplied to the external load 300 without stopping the motor 42. The shutdown power refers to a value of the effective power Pe when the effective power Pe supplied to the external load 300 is gradually increased and the control command unit 52B stops supplying the effective power Pe. As illustrated in FIG. 7, it has been confirmed that the control command unit 52B outputs the switching command Cs that stops the supply of the effective power Pe when the effective power Pe exceeds the maximum power.

### [Second embodiment]

A second embodiment will be described. In the following description, the same or equivalent components as those in the above-described embodiment are designated by the same reference numerals, and the description thereof will be simplified or omitted.

In the above-described embodiment, the monitoring data Md indicates the consumption power Pc of the motor 42. In the present embodiment, the monitoring data Md indicates a rotational speed Rc of the fan 41.

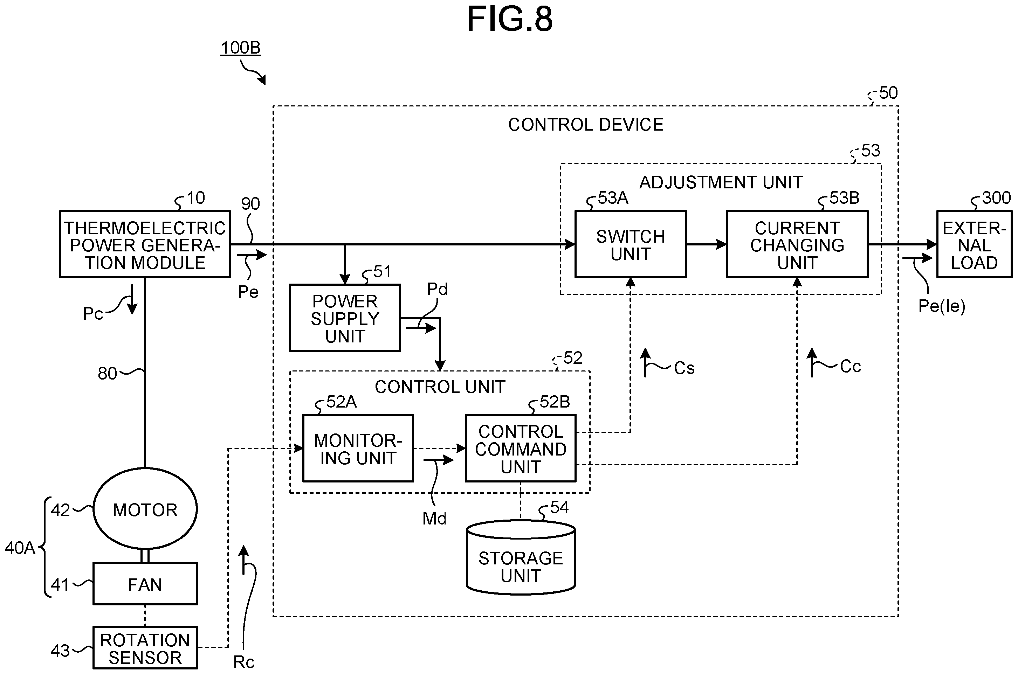

FIG. 8 is a block diagram illustrating a thermoelectric power generator 100B according to the present embodiment. As illustrated in FIG. 8, the monitoring unit 52A monitors the rotational speed Rc of the fan 41 per unit time. In the present embodiment, the thermoelectric power generator 100B includes a rotation sensor 43 that detects the rotational speed Rc of the fan 41. Detection data of the rotation sensor 43 is output to the monitoring unit 52A. By acquiring the detection data of the rotation sensor 43, the monitoring unit 52A can monitor the rotational speed Rc of the fan 41.

An increase in the effective power Pe distributed from the thermoelectric power generation module 10 to the external load 300 will decrease the consumption power Pc distributed to the motor 42. The decrease in the consumption power Pc distributed to the motor 42 decreases the rotational speed Rc of the fan 41. When the rotational speed Rc of the fan 41 decreases, the control command unit 52B decreases the effective power Pe distributed from the thermoelectric power generation module 10 to the external load 300. The decrease in the effective power Pe distributed to the external load 300 will increase the consumption power Pc distributed to the motor 42. An increase in the consumption power Pc increases the rotational speed Rc of the fan 41. This allows the heat dissipater 12 to be sufficiently cooled by the fan 41, increasing the temperature difference between the heat receiver 11 and the heat dissipater 12. This makes it possible to suppress the deterioration in power generation efficiency of the thermoelectric power generation module 10.

### [Third embodiment]

A third embodiment will be described. In the following description, the same or equivalent components as those in the above-described embodiment are designated by the same reference numerals, and the description thereof will be simplified or omitted.

In the above-described embodiment, the monitoring data Md indicates the monitoring result of the state of the cooling device 40A. In the present embodiment, monitoring data Md indicates a state of the thermoelectric power generation module 10. As an example, it is assumed that the monitoring data Md indicates a temperature Tc of the heat dissipater 12 of the thermoelectric power generation module 10 cooled by the cooling device 40A.

The heat dissipater 12 is cooled by the cooling device 40A. The cooling capacity of the cooling device 40A and the temperature Tc of the heat dissipater 12 correspond to each other on a one-to-one basis. By monitoring the temperature Tc of the heat dissipater 12, the monitoring unit 52A can monitor the state of the cooling device 40A.

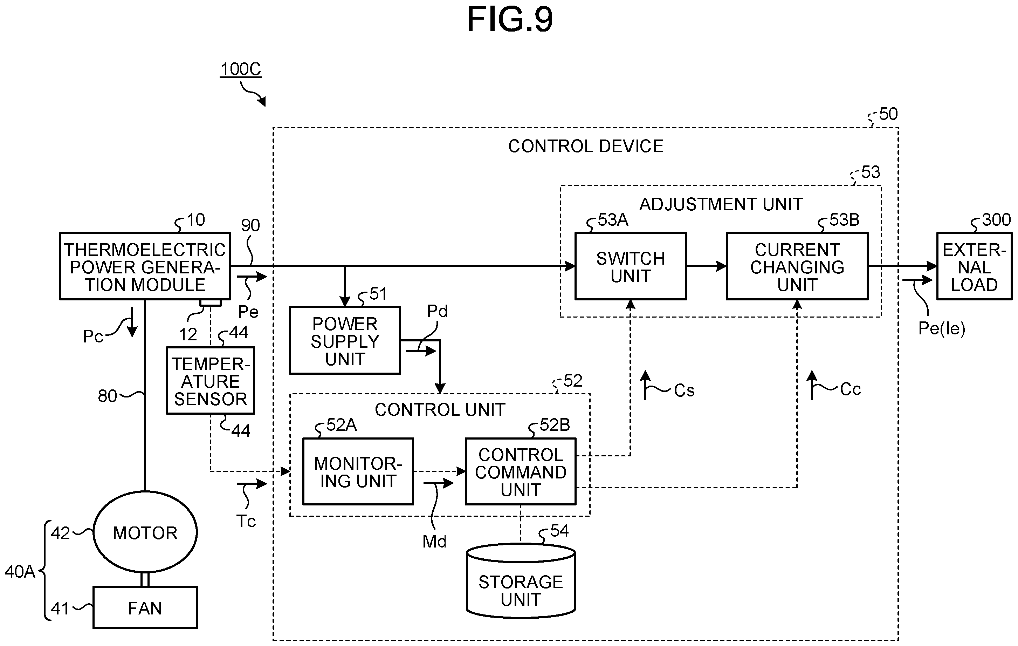

FIG. 9 is a block diagram illustrating a thermoelectric power generator 100C according to the present embodiment. As illustrated in FIG. 9, the monitoring unit 52A monitors the temperature Tc of the heat dissipater 12. In the present embodiment, the thermoelectric power generator 100C includes a temperature sensor 44 that detects the temperature Tc of the heat dissipater 12. The detection data of the temperature sensor 44 is output to the monitoring unit 52A. By acquiring detection data of the temperature sensor 44, the monitoring unit 52A can monitor the temperature Tc of the heat dissipater 12.

An increase in the effective power Pe distributed from the thermoelectric power generation module 10 to the external load 300 will decrease the consumption power Pc distributed to the motor 42. The decrease in the consumption power Pc distributed to the motor 42 decreases the rotational speed Rc of the fan 41. A decrease in the rotational speed Rc of the fan 41 increases the temperature of the heat dissipater 12. When the temperature Tc of the heat dissipater 12 has increased, the control command unit 52B decreases the effective power Pe distributed from the thermoelectric power generation module 10 to the external load 300. The decrease in the effective power Pe distributed to the external load 300 will increase the consumption power Pc distributed to the motor 42. An increase in the consumption power Pc increases the rotational speed Rc of the fan 41. This allows the heat dissipater 12 to be sufficiently cooled by the fan 41, increasing the temperature difference between the heat receiver 11 and the heat dissipater 12. This makes it possible to suppress the deterioration in power generation efficiency of the thermoelectric power generation module 10.

In the present embodiment, the monitoring data Md may indicate the temperature difference between the heat receiver 11 and the heat dissipater 12. By providing not only the temperature sensor 44 that detects the temperature Tc of the heat dissipater 12 but also the temperature sensor that detects the temperature of the heat receiver 11, the monitoring unit 52A can monitor the temperature difference between the heat receiver 11 and the heat dissipater 12. An increase in the effective power Pe distributed from the thermoelectric power generation module 10 to the external load 300 will decrease the consumption power Pc distributed to the motor 42. The decrease in the consumption power Pc distributed to the motor 42 decreases the rotational speed Rc of the fan 41. The decrease in the rotational speed Rc of the fan 41 decreases the temperature difference between the heat receiver 11 and the heat dissipater 12. When the temperature difference between the heat receiver 11 and the heat dissipater 12 has decreased, the control command unit 52B decreases the effective power Pe distributed from the thermoelectric power generation module 10 to the external load 300. The decrease in the effective power Pe distributed to the external load 300 will increase the consumption power Pc distributed to the motor 42. An increase in the consumption power Pc increases the rotational speed Rc of the fan 41. This allows the heat dissipater 12 to be sufficiently cooled by the fan 41, increasing the temperature difference between the heat receiver 11 and the heat dissipater 12. This makes it possible to suppress the deterioration in power generation efficiency of the thermoelectric power generation module 10.

### [Fourth embodiment]

A fourth embodiment will be described. In the following description, the same or equivalent components as those in the above-described embodiment are designated by the same reference numerals, and the description thereof will be simplified or omitted.

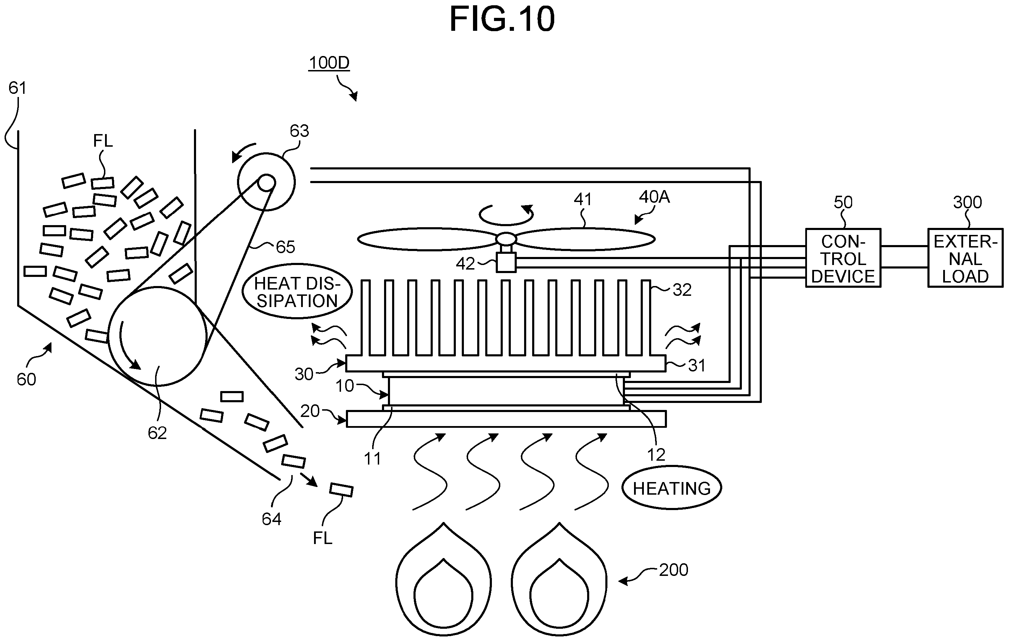

FIG. 10 is a diagram schematically illustrating a thermoelectric power generator 100D according to the present embodiment. As illustrated in FIG. 10, the thermoelectric power generator 100D in the present embodiment includes a thermoelectric power generation module 10 having a heat receiver 11 and a heat dissipater 12, a heat receiving member 20 connected to the heat receiver 11, a heat dissipating member 30 connected to the heat dissipater 12, a cooling device 40A that cools the heat dissipater 12, a heating device 60 that adjusts the temperature of the heat receiver 11, and a control device 50.

As in the above-described embodiments, the control device 50 includes: a control unit 52 including a monitoring unit 52A and a control command unit 52B; and an adjustment unit 53 including a switch unit 53A and a current changing unit 53B.

As in the above-described embodiments, the cooling device 40A includes a fan 41 and a motor 42 that rotates the fan 41. The cooling device 40A cools the heat dissipater 12 via the heat dissipating member 30.

The heat receiver 11 is heated by a heat source 200. The heat source 200 generates heat by burning fuel FL. The heating value of the heat source 200 changes based on the amount of the fuel FL.

The heating device 60 adjusts the amount of the fuel FL supplied to the heat source 200. The larger the amount of the fuel FL supplied to the heat source 200, the higher the heating value of the heat source 200. The smaller the amount of the fuel FL supplied to the heat source 200, the lower the heating value of the heat source 200. The higher the heating value of the heat source 200, the higher the temperature of the heat receiver 11. The lower the heating value of the heat source 200, the lower the temperature of the heat receiver 11. The heating device 60 can adjust the temperature of the heat receiver 11 by adjusting the amount of the fuel FL supplied to the heat source 200.

The heating device 60 includes: a fuel tank 61 that stores the fuel FL; a conveyance member 62 that can convey the fuel FL from the fuel tank 61 to the heat source 200; and a motor 63 that drives the conveyance member 62.

The fuel tank 61 stores the fuel FL. There is provided a supply port 64 at a lower end of the fuel tank 61. The fuel FL of the fuel tank 61 is supplied to the heat source 200 via the supply port 64.

The conveyance member 62 includes a conveyance roller disposed inside the fuel tank 61. Rotation of the conveyance member 62 allows the fuel FL of the fuel tank 61 to be conveyed through the supply port 64. The fuel FL conveyed to the supply port 64 is supplied from the supply port 64 to the heat source 200 by the action of gravity.

The motor 63 is joined to the conveyance member 62 via a power transmission mechanism 65 including a pulley and a belt. The power generated by the motor 63 is transmitted to the conveyance member 62 via the power transmission mechanism 65. The conveyance member 62 is rotated by the power of the motor 63 transmitted from the motor 63 via the power transmission mechanism 65. Driving of the motor 63 causes the fuel FL to be supplied from the fuel tank 61 to the heat source 200. An increased rotational speed of the motor 63 increases the conveyance amount of the fuel FL by the conveyance member 62, leading to an increase in the amount of the fuel FL supplied from the fuel tank 61 to the heat source 200. A decreased rotational speed of the motor 63 decreases the conveyance amount of the fuel FL by the conveyance member 62, leading to a decrease in the amount of the fuel FL supplied from the fuel tank 61 to the heat source 200. When the driving of the motor 63 is stopped, the supply of the fuel FL from the fuel tank 61 to the heat source 200 is stopped.

In the present embodiment, generated power Pg of the thermoelectric power generation module 10 is distributed to the consumption power Pc used in the cooling device 40A, the effective power Pe used in the external load 300, and the consumption power Ph used in the heating device 60. The consumption power Ph refers to the power supplied from the thermoelectric power generation module 10 to the heating device 60 and consumed by the heating device 60. The consumption power Pc of the cooling device 40A includes the consumption power Pc of the motor 42. The consumption power Ph of the heating device 60 includes the consumption power Ph of the motor 63. The generated power Pg, the consumption power Pc, the effective power Pe, and the consumption power Ph have a relationship expressed by the following Formula (2).

[Effective power Pe] = [generated power Pg] - ([consumption power Pc] + [consumption power Ph])

The monitoring unit 52A of the control device 50 monitors individual states of the cooling device 40A and the heating device 60 and outputs monitoring data Md. In the present embodiment, the monitoring data Md includes the consumption power Pc of the motor 42 of the cooling device 40A and the consumption power Ph of the motor 63 of the heating device 60.

The control command unit 52B of the control device 50 outputs a control command that controls the adjustment unit 53 based on the monitoring data Md output from the monitoring unit 52A.

The control command unit 52B performs control according to the determinations based on the monitoring data Md, so as to decrease the effective power Pe when having determined that the consumption power Pc of the cooling device 40A has decreased, and so as to decrease the effective power Pe when having determined that the consumption power Ph of the heating device 60 has decreased.

The increase in the effective power Pe distributed from the thermoelectric power generation module 10 to the external load 300 will decrease each of the consumption power Pc distributed to the motor 42 and the consumption power Ph distributed to the motor 63.

When the consumption power Pc distributed from the thermoelectric power generation module 10 to the motor 42 decreases, the control command unit 52B decreases the effective power Pe distributed from the thermoelectric power generation module 10 to the external load 300. The decrease in the effective power Pe distributed to the external load 300 will increase the consumption power Pc distributed to the motor 42. With the increase in the consumption power Pc distributed to the motor 42, it is possible to suppress the decrease in the rotational speed of the fan 41 and the stop of the rotation of the fan 41.

Moreover, when the consumption power Pc distributed from the thermoelectric power generation module 10 to the motor 63 decreases, the control command unit 52B decreases the effective power Pe distributed from the thermoelectric power generation module 10 to the external load 300. The decrease in the effective power Pe distributed to the external load 300 will increase the consumption power Pc distributed to the motor 63. With the increase in the consumption power Pc distributed to the motor 63, it is possible to suppress a decrease in the amount of the fuel FL supplied to the heat source 200 and stop of the supply of the fuel FL.

Since the heat receiver 11 is sufficiently heated by the heat source 200 and the heat dissipater 12 is sufficiently cooled by the cooling device 40A, the temperature difference between the heat receiver 11 and the heat dissipater 12 increases. This makes it possible to suppress the deterioration in power generation efficiency of the thermoelectric power generation module 10.

In the present embodiment, the monitoring data Md may indicate the temperature difference between the heat receiver 11 and the heat dissipater 12. By providing the temperature sensor that detects the temperature of the heat receiver 11 and the temperature sensor that detects the temperature of the heat dissipater 12, the monitoring unit 52A can monitor the temperature difference between the heat receiver 11 and the heat dissipater 12. When the temperature difference between the heat receiver 11 and the heat dissipater 12 has decreased, the control command unit 52B decreases the effective power Pe distributed from the thermoelectric power generation module 10 to the external load 300. With the decreased effective power Pe distributed to the external load 300, the consumption power Pc distributed to the motor 42 and the consumption power Ph distributed to the motor 63 increase. This increases the temperature difference between the heat receiver 11 and the heat dissipater 12. This makes it possible to suppress the deterioration in power generation efficiency of the thermoelectric power generation module 10.

### [Fifth embodiment]

A fifth embodiment will be described. In the following description, the same or equivalent components as those in the above-described embodiment are designated by the same reference numerals, and the description thereof will be simplified or omitted.

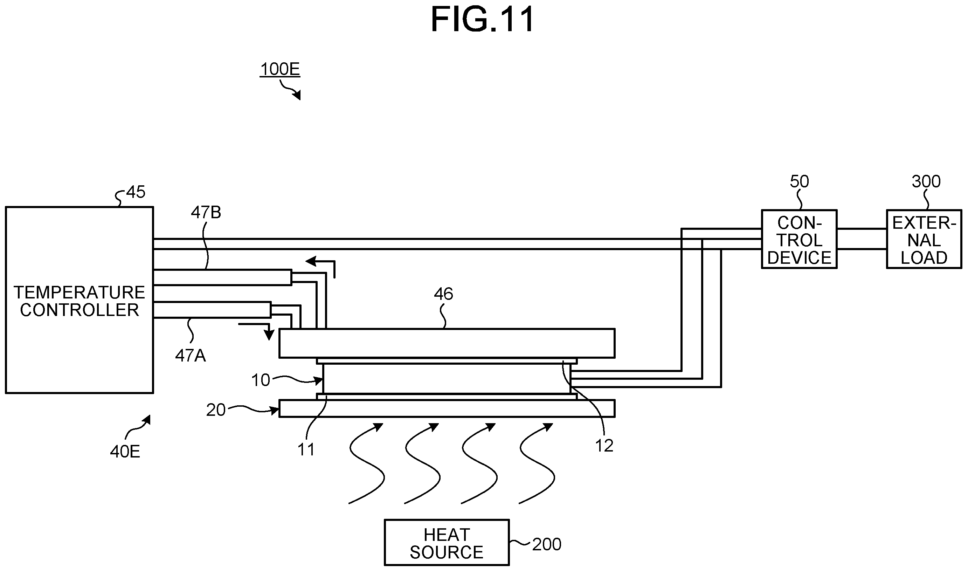

FIG. 11 is a view schematically illustrating a thermoelectric power generator 100E according to the present embodiment. In the above-described embodiments, the heat dissipater 12 is cooled by the cooling device 40A including the fan 41 and the motor 42. In the present embodiment, a cooling device 40E that cools the heat dissipater 12 includes: a temperature controller 45 that adjusts the temperature of the refrigerant; a refrigerant jacket 46 connected to the heat dissipater 12; a first channel 47A that allows passage of the refrigerant supplied from the temperature controller 45 to the refrigerant jacket 46; and a second channel 47B that allows passage of the refrigerant supplied from the refrigerant jacket 46 to the temperature controller 45. The refrigerant circulates in a circulation system of the cooling device 40E including the temperature controller 45, the first channel 47A, the refrigerant jacket 46, and the second channel 47B.

The temperature controller 45 adjusts the temperature of the refrigerant. The temperature controller 45 includes, for example, a heat exchanger and a circulation pump, adjusts the temperature of the refrigerant, and supplies the temperature-adjusted refrigerant to the refrigerant jacket 46. The heat exchanger and the circulation pump of the temperature controller 45 are driven by the consumption power Pc supplied from the thermoelectric power generation module 10.

The refrigerant jacket 46 has an internal space through which the refrigerant flows. The refrigerant jacket 46 is disposed in contact with the heat dissipater 12. The refrigerant whose temperature has been controlled by the temperature controller 45 is supplied to the refrigerant jacket 46 via the first channel 47A. The refrigerant flowing through the internal space of the refrigerant jacket 46 takes heat from the heat dissipater 12 and then returns to the temperature controller 45 via the second channel 47B.

The generated power Pg of the thermoelectric power generation module 10 is distributed to the consumption power Pc used in the temperature controller 45 of the cooling device 40E and the effective power Pe used in the external load 300. The monitoring unit 52A monitors the consumption power Pc of the temperature controller 45 and outputs the monitoring data Md. When the consumption power Pc of the temperature controller 45 decreases, the control command unit 52B decreases the effective power Pe of the external load 300.

### [Sixth embodiment]

A sixth embodiment will be described. In the following description, the same or equivalent components as those in the above-described embodiment are designated by the same reference numerals, and the description thereof will be simplified or omitted.

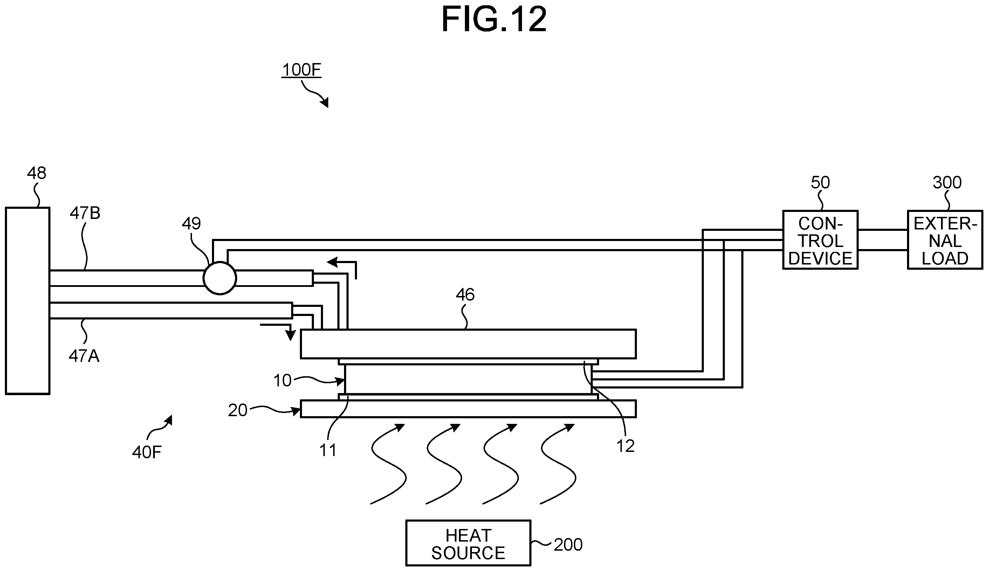

FIG. 12 is a view schematically illustrating a thermoelectric power generator 100F according to the present embodiment. In the fifth embodiment described above, the cooling device 40E includes the temperature controller 45. In the present embodiment, a cooling device 40F that cools the heat dissipater 12 includes: a radiator 48 that radiates heat from the refrigerant; a refrigerant jacket 46 connected to the heat dissipater 12; a first channel 47A that allows passage of the refrigerant supplied from the temperature controller 45 to the refrigerant jacket 46; a second channel 47B that allows passage of the refrigerant supplied from the refrigerant jacket 46 to the temperature controller 45; and a circulation pump 49 disposed in the second channel 47B. The refrigerant circulates in a circulation system including the radiator 48, the first channel 47A, the refrigerant jacket 46, and the second channel 47B.

The radiator 48 radiates heat from the refrigerant. The refrigerant whose temperature has been lowered by the radiator 48 is supplied to the refrigerant jacket 46 via the first channel 47A. The refrigerant flowing through the internal space of the refrigerant jacket 46 takes heat from the heat dissipater 12 and then returns to the radiator 48 via the second channel 47B. The circulation pump 49 is driven to circulate the refrigerant through the circulation system of the cooling device 40F. The circulation pump 49 is driven by the consumption power Pc supplied from the thermoelectric power generation module 10.

The generated power Pg of the thermoelectric power generation module 10 is distributed to the consumption power Pc used in the circulation pump 49 of the cooling device 40F and the effective power Pe used in the external load 300. The monitoring unit 52A monitors the consumption power Pc of the circulation pump 49 and outputs the monitoring data Md. When the consumption power Pc of the circulation pump 49 decreases, the control command unit 52B decreases the effective power Pe of the external load 300.

### Reference Signs List

10 THERMOELECTRIC POWER GENERATION MODULE
11 HEAT RECEIVER
11S OUTER SURFACE
11T INNER SURFACE
12 HEAT DISSIPATER
12S OUTER SURFACE
12T INNER SURFACE
13 THERMOELECTRIC SEMICONDUCTOR ELEMENT
13P p-TYPE THERMOELECTRIC SEMICONDUCTOR ELEMENT
13N n-TYPE THERMOELECTRIC SEMICONDUCTOR ELEMENT
14 LEAD WIRE
15 FIRST ELECTRODE
16 SECOND ELECTRODE
20 HEAT RECEIVING MEMBER
30 HEAT DISSIPATING MEMBER
31 PLATE PORTION
32 FIN PORTION
40A COOLING DEVICE
40E COOLING DEVICE
40F COOLING DEVICE
41 FAN
42 MOTOR
43 ROTATION SENSOR
44 TEMPERATURE SENSOR
45 TEMPERATURE CONTROLLER
46 REFRIGERANT JACKET
47A FIRST CHANNEL
47B SECOND CHANNEL
48 RADIATOR
49 CIRCULATION PUMP
50 CONTROL DEVICE
51 POWER SUPPLY UNIT
52 CONTROL UNIT
52A MONITORING UNIT
52B CONTROL COMMAND UNIT
53 ADJUSTMENT UNIT
53A SWITCH UNIT
53B CURRENT CHANGING UNIT
54 STORAGE UNIT
60 HEATING DEVICE
61 FUEL TANK
62 CONVEYANCE MEMBER
63 MOTOR
64 SUPPLY PORT
65 POWER TRANSMISSION MECHANISM
80 FIRST POWER LINE
90 SECOND POWER LINE
100A THERMOELECTRIC POWER GENERATOR
100B THERMOELECTRIC POWER GENERATOR
100C THERMOELECTRIC POWER GENERATOR
100D THERMOELECTRIC POWER GENERATOR
100E THERMOELECTRIC POWER GENERATOR
100F THERMOELECTRIC POWER GENERATOR
200 HEAT SOURCE
300 EXTERNAL LOAD
Cc CHANGE COMMAND
Cs SWITCHING COMMAND
Ie CURRENT
Ie1 FIRST PREDETERMINED VALUE
Ie2 SECOND PREDETERMINED VALUE
Md MONITORING DATA
Pc CONSUMPTION POWER
Pd DRIVE POWER
Pe EFFECTIVE POWER
Pg GENERATED POWER
Ph CONSUMPTION POWER
Rc ROTATIONAL SPEED
Sh THRESHOLD
Shp STOP THRESHOLD
Shs START THRESHOLD
Shv CHANGE THRESHOLD
Shv1 FIRST CHANGE THRESHOLD
Shv2 SECOND CHANGE THRESHOLD
Shv3 THIRD CHANGE THRESHOLD
Tc TEMPERATURE
Vc VOLTAGE
ΔIe SPECIFIED AMOUNT

## Claims

1. A thermoelectric power generator comprising:
a thermoelectric power generation module (10) that includes a heat receiver (11) and a heat dissipater (12) and generates electric power by a temperature difference between the heat receiver (11) and the heat dissipater (12) ;
a cooling device (40A, 40E, 40F) that cools the heat dissipater (12); and
a control device (50), **characterised in that** generated power of the thermoelectric power generation module (10) is distributed to consumption power used in the cooling device (40A, 40E, 40F) and effective power used in an external load (300), and
the control device (50) includes:
a monitoring unit (52A) that monitors a state of the cooling device (40A, 40E, 40F) and outputs monitoring data;
an adjustment unit (53) capable of adjusting the effective power supplied to the external load (300); and
a control command unit (52B) that outputs a control command that controls the adjustment unit (53) based on the monitoring data.

2. The thermoelectric power generator according to claim 1,
wherein the monitoring data includes consumption power of the cooling device (40A, 40E, 40F), and
the control command unit (52B) decreases the effective power when consumption power of the cooling device (40A, 40E, 40F) has decreased.

3. The thermoelectric power generator according to claim 2,
wherein the cooling device (40A, 40E, 40F) includes a motor (42), and
the consumption power of the cooling device (40A, 40E, 40F) includes the consumption power of the motor (42).

4. The thermoelectric power generator according to claim 2 or 3, further comprising
a storage unit (54) that stores a threshold related to the consumption power,
wherein the control command unit (52B) outputs the control command based on a result of comparison between the consumption power of the cooling device (40A, 40E, 40F) and the threshold.

5. The thermoelectric power generator according to claim 4,
wherein the threshold includes a change threshold related to a change in the value of the effective power, and
the control command unit (52B) decreases the effective power by a specified amount when the consumption power of the cooling device (40A, 40E, 40F) has decreased to the change threshold or below.

6. The thermoelectric power generator according to claim 5,
wherein the threshold includes a stop threshold related to stop of supply of the effective power, and
the control command unit (52B) stops the supply of the effective power when the consumption power of the cooling device (40A, 40E, 40F) has decreased to the stop threshold or below.

7. The thermoelectric power generator according to any one of claims 2 to 6,
wherein the consumption power of the cooling device (40A, 40E, 40F) includes a voltage applied to the cooling device (40A, 40E, 40F), and
the effective power of the external load (300) includes a current supplied to the external load (300).

8. The thermoelectric power generator according to claim 1 or 2,
wherein the cooling device (40A, 40E, 40F) includes a fan (41) and a motor (42) that rotates the fan (41),
the monitoring data includes a rotational speed of the fan (41), and
the control command unit (52B) decreases the effective power when the rotational speed has decreased.

9. The thermoelectric power generator according to any one of claims 1 to 8,
wherein the monitoring unit (52A) monitors a state of the thermoelectric power generation module (10) and outputs the monitoring data, and
the control command unit (52B) outputs the control command based on the monitoring data.

10. A thermoelectric power generator comprising:
a thermoelectric power generation module (10) that includes a heat receiver (11) and a heat dissipater (12) and generates electric power by a temperature difference between the heat receiver (11) and the heat dissipater (12) ;
a cooling device (40A, 40E, 40F) that cools the heat dissipater (12); and
a control device (50), **characterised in that** generated power of the thermoelectric power generation module (10) is distributed to consumption power used in the cooling device (40A, 40E, 40F) and effective power used in an external load (300), and
the control device (50) includes:
a monitoring unit (52A) that monitors a state of the thermoelectric power generation module (10) and outputs monitoring data;
an adjustment unit (53) capable of adjusting the effective power supplied to the external load (300); and
a control command unit (52B) that outputs a control command that controls the adjustment unit (53) based on the monitoring data.

11. The thermoelectric power generator according to claim 9 or 10,
wherein the monitoring data includes a temperature of the heat dissipater (12) cooled by the cooling device (40A, 40E, 40F), and
the control command unit (52B) decreases the effective power when the temperature has increased.

12. The thermoelectric power generator according to any one of claims 1 to 11, further comprising
a heating device (60) that adjusts a temperature of the heat receiver (11),
wherein generated power of the thermoelectric power generation module (10) is distributed to consumption power used in the cooling device (40A, 40E, 40F), effective power used in the external load (300), and consumption power used in the heating device (60),
the monitoring unit (52A) monitors a state of the heating device (60) and outputs the monitoring data, and
the control command unit (52B) outputs the control command based on the monitoring data.

13. A thermoelectric power generator comprising:
a thermoelectric power generation module (10) that includes a heat receiver (11) and a heat dissipater (12) and generates electric power by a temperature difference between the heat receiver (11) and the heat dissipater (12) ;
a cooling device (40A, 40E, 40F) that cools the heat dissipater (12);
a heating device (60) that adjusts a temperature of the heat receiver (11); and
a control device (50), **characterised in that** generated power of the thermoelectric power generation module (10) is distributed to consumption power used in the cooling device (40A, 40E, 40F), effective power used in an external load (300), and consumption power used in the heating device (60), and
the control device (50) includes:
a monitoring unit (52A) that monitors each of a state of the cooling device (40A, 40E, 40F) and a state of the heating device (60) and outputs monitoring data;
an adjustment unit (53) capable of adjusting the effective power supplied to the external load (300); and
a control command unit (52B) that outputs a control command that controls the adjustment unit (53) based on the monitoring data.

14. The thermoelectric power generator according to claim 13,
wherein the monitoring data includes: the consumption power of the cooling device (40A, 40E, 40F); and the consumption power of the heating device (60), and
the control command unit (52B) decreases the effective power when the consumption power of the cooling device (40A, 40E, 40F) has decreased, and decreases the effective power when the consumption power of the heating device (60) has decreased.

15. The thermoelectric power generator according to any one of claims 1 to 14, further comprising
a first power line (80) that connects the thermoelectric power generation module (10) and the cooling device (40A, 40E, 40F) to each other; and
a second power line (90) that connects the thermoelectric power generation module (10) and the external load (300) to each other,
wherein the adjustment unit (53) is disposed in the second power line (90).

## Patentansprüche

1. Thermoelektrische Energieerzeugungsvorrichtung, die Folgendes umfasst:
ein thermoelektrisches Energieerzeugungsmodul (10), das einen Wärmeempfänger (11) und einen Wärmeableiter (12) enthält und elektrische Energie durch eine Temperaturdifferenz zwischen dem Wärmeempfänger (11) und dem Wärmeableiter (12) erzeugt;
eine Kühlvorrichtung (40A, 40E, 40F), die den Wärmeableiter (12) kühlt; und
eine Steuervorrichtung (50),
**dadurch gekennzeichnet, dass** die erzeugte Energie des thermoelektrischen Energieerzeugungsmoduls (10) auf die in der Kühlvorrichtung (40A, 40E, 40F) verwendete Verbrauchsleistung und die in einer externen Last (300) verwendete Wirkleistung verteilt wird, und
die Steuervorrichtung (50) umfasst:
eine Überwachungseinheit (52A), die einen Zustand der Kühlvorrichtung (40A, 40E, 40F) überwacht und Überwachungsdaten ausgibt;
eine Einstelleinheit (53), die in der Lage ist, die der externen Last (300) zugeführte Wirkleistung einzustellen; und
eine Steuerbefehlseinheit (52B), die einen Steuerbefehl ausgibt, der die Einstelleinheit (53) basierend auf den Überwachungsdaten steuert.

2. Thermoelektrische Energieerzeugungsvorrichtung nach Anspruch 1,
wobei die Überwachungsdaten die Verbrauchsleistung der Kühlvorrichtung (40A, 40E, 40F) umfassen, und
die Steuerbefehlseinheit (52B) die Wirkleistung verringert, wenn die Verbrauchsleistung der Kühlvorrichtung (40A, 40E, 40F) gesunken ist.

3. Thermoelektrische Energieerzeugungsvorrichtung nach Anspruch 2,
wobei die Kühlvorrichtung (40A, 40E, 40F) einen Motor (42) umfasst, und
die Verbrauchsleistung der Kühlvorrichtung (40A, 40E, 40F) schließt die Verbrauchsleistung des Motors (42) ein.

4. Thermoelektrische Energieerzeugungsvorrichtung nach Anspruch 2 oder 3, die außerdem Folgendes umfasst
eine Speichereinheit (54), die einen Schwellenwert in Bezug auf die Verbrauchsleistung speichert,
wobei die Steuerbefehlseinheit (52B) den Steuerbefehl auf der Grundlage eines Ergebnisses des Vergleichs zwischen der Verbrauchsleistung der Kühlvorrichtung (40A, 40E, 40F) und dem Schwellenwert ausgibt.

5. Thermoelektrische Energieerzeugungsvorrichtung nach Anspruch 4,
wobei der Schwellenwert einen Änderungsschwellenwert enthält, der sich auf eine Änderung des Werts der Wirkleistung bezieht, und
die Steuerbefehlseinheit (52B) die Wirkleistung um einen bestimmten Betrag verringert, wenn die Verbrauchsleistung der Kühlvorrichtung (40A, 40E, 40F) auf den Änderungsschwellenwert oder darunter gesunken ist.

6. Thermoelektrische Energieerzeugungsvorrichtung nach Anspruch 5,
wobei der Schwellenwert einen Stopp-Schwellenwert enthält, der sich auf die Beendigung der Lieferung der Wirkleistung bezieht, und
die Steuerbefehlseinheit (52B) die Zufuhr der Wirkleistung stoppt, wenn die Verbrauchsleistung der Kühlvorrichtung (40A, 40E, 40F) auf den Stopp-Schwellenwert oder darunter gesunken ist.

7. Thermoelektrische Energieerzeugungsvorrichtung nach einem der Ansprüche 2 bis 6,
wobei die Verbrauchsleistung der Kühlvorrichtung (40A, 40E, 40F) eine an die Kühlvorrichtung (40A, 40E, 40F) angelegte Spannung umfasst, und
die Wirkleistung der externen Last (300) einen der externen Last (300) zugeführten Strom umfasst.

8. Thermoelektrische Energieerzeugungsvorrichtung nach Anspruch 1 oder 2,
wobei die Kühlvorrichtung (40A, 40E, 40F) ein Gebläse (41) und einen Motor (42) umfasst, der das Gebläse (41) in Drehung versetzt,
die Überwachungsdaten eine Drehzahl des Gebläses (41) umfassen, und
die Steuerbefehlseinheit (52B) die Wirkleistung verringert, wenn die Drehzahl gesunken ist.

9. Thermoelektrische Energieerzeugungsvorrichtung nach einem der Ansprüche 1 bis 8,
wobei die Überwachungseinheit (52A) einen Zustand des thermoelektrischen Energieerzeugungsmoduls (10) überwacht und die Überwachungsdaten ausgibt, und
die Steuerbefehlseinheit (52B) den Steuerbefehl auf der Grundlage der Überwachungsdaten ausgibt.

10. Thermoelektrische Energieerzeugungsvorrichtung, die Folgendes umfasst:
ein thermoelektrisches Energieerzeugungsmodul (10), das einen Wärmeempfänger (11) und einen Wärmeableiter (12) umfasst und durch eine Temperaturdifferenz zwischen dem Wärmeempfänger (11) und dem Wärmeableiter (12) elektrische Energie erzeugt;
eine Kühlvorrichtung (40A, 40E, 40F), die den Wärmeableiter (12) kühlt; und
eine Steuervorrichtung (50),
**dadurch gekennzeichnet, dass** die erzeugte Energie des thermoelektrischen Energieerzeugungsmoduls (10) auf die in der Kühlvorrichtung (40A, 40E, 40F) verwendete Verbrauchsleistung und die in einer externen Last (300) verwendete Wirkleistung verteilt wird, und
die Steuervorrichtung (50) umfasst:
eine Überwachungseinheit (52A), die einen Zustand des thermoelektrischen Energieerzeugungsmoduls (10) überwacht und Überwachungsdaten ausgibt;
eine Einstelleinheit (53), die in der Lage ist, die der externen Last (300) zugeführte Wirkleistung einzustellen; und
eine Steuerbefehlseinheit (52B), die einen Steuerbefehl ausgibt, der die Einstelleinheit (53) basierend auf den Überwachungsdaten steuert.

11. Thermoelektrische Energieerzeugungsvorrichtung nach Anspruch 9 oder 10,
wobei die Überwachungsdaten eine Temperatur des durch die Kühlvorrichtung (40A, 40E, 40F) gekühlten Wärmeableiters (12) umfassen, und
die Steuerbefehlseinheit (52B) die Wirkleistung verringert, wenn die Temperatur gestiegen ist.

12. Thermoelektrische Energieerzeugungsvorrichtung nach einem der Ansprüche 1 bis 11, ferner umfassend
eine Heizvorrichtung (60), die eine Temperatur des Wärmeempfängers (11) einstellt,
wobei die erzeugte Energie des thermoelektrischen Energieerzeugungsmoduls (10) auf die in der Kühlvorrichtung (40A, 40E, 40F) verwendete Verbrauchsleistung, die in der externen Last (300) verwendete Wirkleistung und die in der Heizvorrichtung (60) verwendete Verbrauchsleistung verteilt wird,
die Überwachungseinheit (52A) einen Zustand der Heizvorrichtung (60) überwacht und die Überwachungsdaten ausgibt, und
die Steuerbefehlseinheit (52B) den Steuerbefehl auf der Grundlage der Überwachungsdaten ausgibt.

13. Thermoelektrische Energieerzeugungsvorrichtung, die Folgendes umfasst:
ein thermoelektrisches Energieerzeugungsmodul (10), das einen Wärmeempfänger (11) und einen Wärmeableiter (12) enthält und elektrische Energie durch eine Temperaturdifferenz zwischen dem Wärmeempfänger (11) und dem Wärmeableiter (12) erzeugt;
eine Kühlvorrichtung (40A, 40E, 40F), die den Wärmeableiter (12) kühlt;
eine Heizvorrichtung (60), die eine Temperatur des Wärmeempfängers (11) einstellt; und
eine Steuervorrichtung (50),
**dadurch gekennzeichnet, dass** die erzeugte Energie des thermoelektrischen Energieerzeugungsmoduls (10) auf die in der Kühlvorrichtung (40A, 40E, 40F) verwendete Verbrauchsleistung, die in einer externen Last (300) verwendete Wirkleistung und die in der Heizvorrichtung (60) verwendete Verbrauchsleistung verteilt wird, und
die Steuervorrichtung (50) umfasst:
eine Überwachungseinheit (52A), die jeweils einen Zustand der Kühlvorrichtung (40A, 40E, 40F) und einen Zustand der Heizvorrichtung (60) überwacht und Überwachungsdaten ausgibt;
eine Einstelleinheit (53), die in der Lage ist, die der externen Last (300) zugeführte Wirkleistung einzustellen; und
eine Steuerbefehlseinheit (52B), die einen Steuerbefehl ausgibt, der die Einstelleinheit (53) basierend auf den Überwachungsdaten steuert.

14. Thermoelektrische Energieerzeugungsvorrichtung nach Anspruch 13,
wobei die Überwachungsdaten umfassen: die Verbrauchsleistung der Kühlvorrichtung (40A, 40E, 40F); und die Verbrauchsleistung der Heizvorrichtung (60), und
die Steuerbefehlseinheit (52B) die Wirkleistung verringert, wenn die Verbrauchsleistung der Kühlvorrichtung (40A, 40E, 40F) abgenommen hat, und die Wirkleistung verringert, wenn die Verbrauchsleistung der Heizvorrichtung (60) abgenommen hat.

15. Thermoelektrische Energieerzeugungsvorrichtung nach einem der Ansprüche 1 bis 14, ferner umfassend
eine erste Stromleitung (80), die das thermoelektrische Stromerzeugungsmodul (10) und die Kühlvorrichtung (40A, 40E, 40F) miteinander verbindet; und
eine zweite Stromleitung (90), die das thermoelektrische Stromerzeugungsmodul (10) und die externe Last (300) miteinander verbindet,
wobei die Einstelleinheit (53) in der zweiten Stromleitung (90) angeordnet ist.

## Revendications

1. Générateur d'énergie thermoélectrique comprenant:
un module de production d'énergie thermoélectrique (10) qui comprend un récepteur de chaleur (11) et un dissipateur de chaleur (12) et génère de l'énergie électrique par une différence de température entre le récepteur de chaleur (11) et le dissipateur de chaleur (12) ;
un dispositif de refroidissement (40A, 40E, 40F) qui refroidit le dissipateur de chaleur (12); et
un dispositif de contrôle (50),
**caractérisé par le fait que** la puissance générée par le module de génération d'énergie thermoélectrique (10) est distribuée à la puissance de consommation utilisée dans le dispositif de refroidissement (40A, 40E, 40F) et à la puissance effective utilisée dans une charge externe (300), et
le dispositif de contrôle (50) comprend:
une unité de surveillance (52A) qui surveille l'état du dispositif de refroidissement (40A, 40E, 40F) et fournit des données de surveillance;
une unité de réglage (53) capable de régler la puissance effective fournie à la charge externe (300) ; et
une unité de commande de contrôle (52B) qui émet une commande de contrôle qui contrôle l'unité de réglage (53) sur la base des données de surveillance.

2. Générateur d'énergie thermoélectrique selon la revendication 1,
dans lequel les données de surveillance comprennent la puissance de consommation du dispositif de refroidissement (40A, 40E, 40F), et
l'unité de contrôle-commande (52B) diminue la puissance effective lorsque la puissance de consommation du dispositif de refroidissement (40A, 40E, 40F) a diminué.

3. Générateur d'énergie thermoélectrique selon la revendication 2,
dans lequel le dispositif de refroidissement (40A, 40E, 40F) comprend un moteur (42), et
la puissance de consommation du dispositif de refroidissement (40A, 40E, 40F) comprend la puissance de consommation du moteur (42).

4. Générateur d'énergie thermoélectrique selon la revendication 2 ou 3, comprenant en outre
une unité de stockage (54) qui stocke un seuil lié à la puissance de consommation,
l'unité de commande de contrôle (52B) émet la commande de contrôle sur la base du résultat de la comparaison entre la puissance de consommation du dispositif de refroidissement (40A, 40E, 40F) et le seuil.

5. Générateur d'énergie thermoélectrique selon la revendication 4,
dans lequel le seuil comprend un seuil de changement lié à un changement de la valeur de la puissance effective, et
l'unité de contrôle-commande (52B) diminue la puissance effective d'un montant spécifié lorsque la puissance de consommation du dispositif de refroidissement (40A, 40E, 40F) a diminué jusqu'au seuil de changement ou en dessous.

6. Générateur d'énergie thermoélectrique selon la revendication 5,
dans lequel le seuil comprend un seuil d'arrêt lié à l'arrêt de la fourniture de la puissance effective, et
l'unité de contrôle-commande (52B) arrête la fourniture de la puissance effective lorsque la puissance de consommation du dispositif de refroidissement (40A, 40E, 40F) a diminué jusqu'au seuil d'arrêt ou en deçà.

7. Générateur d'énergie thermoélectrique selon l'une des revendications 2 à 6,
dans lequel la puissance de consommation du dispositif de refroidissement (40A, 40E, 40F) comprend une tension appliquée au dispositif de refroidissement (40A, 40E, 40F), et
la puissance effective de la charge externe (300) comprend un courant fourni à la charge externe (300).

8. Générateur d'énergie thermoélectrique selon la revendication 1 ou 2,
le dispositif de refroidissement (40A, 40E, 40F) comprend un ventilateur (41) et un moteur (42) qui fait tourner le ventilateur (41),
les données de surveillance comprennent une vitesse de rotation du ventilateur (41), et
l'unité de contrôle-commande (52B) diminue la puissance effective lorsque la vitesse de rotation a diminué.

9. Générateur thermoélectrique selon l'une des revendications 1 à 8,
dans lequel l'unité de surveillance (52A) surveille un état du module de production d'énergie thermoélectrique (10) et émet les données de surveillance, et
l'unité de commande de contrôle (52B) émet la commande de contrôle sur la base des données de surveillance.

10. Générateur d'énergie thermoélectrique comprenant:
un module de production d'énergie thermoélectrique (10) qui comprend un récepteur de chaleur (11) et un dissipateur de chaleur (12) et génère de l'énergie électrique par une différence de température entre le récepteur de chaleur (11) et le dissipateur de chaleur (12) ;
un dispositif de refroidissement (40A, 40E, 40F) qui refroidit le dissipateur de chaleur (12); et
un dispositif de contrôle (50),
**caractérisé par le fait que** la puissance générée par le module de génération d'énergie thermoélectrique (10) est distribuée à la puissance de consommation utilisée dans le dispositif de refroidissement (40A, 40E, 40F) et à la puissance effective utilisée dans une charge externe (300), et
le dispositif de contrôle (50) comprend:
une unité de surveillance (52A) qui surveille l'état du module de production d'énergie thermoélectrique (10) et émet des données de surveillance;
une unité de réglage (53) capable de régler la puissance effective fournie à la charge externe (300) ; et
une unité de commande de contrôle (52B) qui émet une commande de contrôle qui contrôle l'unité de réglage (53) sur la base des données de surveillance.

11. Générateur d'énergie thermoélectrique selon la revendication 9 ou 10,
dans lequel les données de surveillance comprennent une température du dissipateur de chaleur (12) refroidi par le dispositif de refroidissement (40A, 40E, 40F), et
l'unité de contrôle-commande (52B) diminue la puissance effective lorsque la température a augmenté.

12. Générateur d'énergie thermoélectrique selon l'une des revendications 1 à 11, comprenant en outre
un dispositif de chauffage (60) qui ajuste la température du récepteur de chaleur (11),
dans lequel la puissance générée par le module de génération d'énergie thermoélectrique (10) est distribuée à la puissance de consommation utilisée dans le dispositif de refroidissement (40A, 40E, 40F), à la puissance effective utilisée dans la charge externe (300) et à la puissance de consommation utilisée dans le dispositif de chauffage (60),
l'unité de surveillance (52A) surveille un état du dispositif de chauffage (60) et émet les données de surveillance, et
l'unité de commande de contrôle (52B) émet la commande de contrôle sur la base des données de surveillance.

13. Générateur d'énergie thermoélectrique comprenant:
un module de production d'énergie thermoélectrique (10) qui comprend un récepteur de chaleur (11) et un dissipateur de chaleur (12) et génère de l'énergie électrique par une différence de température entre le récepteur de chaleur (11) et le dissipateur de chaleur (12) ;
un dispositif de refroidissement (40A, 40E, 40F) qui refroidit le dissipateur de chaleur (12);
un dispositif de chauffage (60) qui ajuste la température du récepteur de chaleur (11); et
un dispositif de contrôle (50),
**caractérisé par le fait que** la puissance générée par le module de génération d'énergie thermoélectrique (10) est distribuée à la puissance de consommation utilisée dans le dispositif de refroidissement (40A, 40E, 40F), à la puissance effective utilisée dans une charge externe (300) et à la puissance de consommation utilisée dans le dispositif de chauffage (60), et
le dispositif de contrôle (50) comprend:
une unité de surveillance (52A) qui surveille l'état du dispositif de refroidissement (40A, 40E, 40F) et l'état du dispositif de chauffage (60) et fournit des données de surveillance;
une unité de réglage (53) capable de régler la puissance effective fournie à la charge externe (300); et
une unité de commande de contrôle (52B) qui émet une commande de contrôle qui contrôle l'unité de réglage (53) sur la base des données de surveillance.

14. Générateur d'énergie thermoélectrique selon la revendication 13,
dans lequel les données de surveillance comprennent : la puissance de consommation du dispositif de refroidissement (40A, 40E, 40F); et la puissance de consommation du dispositif de chauffage (60), et
l'unité de contrôle-commande (52B) diminue la puissance effective lorsque la puissance de consommation du dispositif de refroidissement (40A, 40E, 40F) a diminué, et diminue la puissance effective lorsque la puissance de consommation du dispositif de chauffage (60) a diminué.

15. Générateur d'énergie thermoélectrique selon l'une des revendications 1 à 14, comprenant en outre
une première ligne d'alimentation (80) qui relie le module de production d'énergie thermoélectrique (10) et le dispositif de refroidissement (40A, 40E, 40F) l'un à l'autre; et
une deuxième ligne d'alimentation (90) qui relie le module de production d'énergie thermoélectrique (10) et la charge externe (300) l'un à l'autre,
dans lequel l'unité de réglage (53) est disposée dans la seconde ligne d'alimentation (90).
